(19) Europäisches Patentamt
European Patent Office
Office européen des brevets

(11) Publication number: **0 343 246 B1**

(12) **EUROPEAN PATENT SPECIFICATION**

(45) Date of publication of patent specification: **09.02.94**

(51) Int. Cl.5: **C08F 20/12**, C08F 26/00, C08F 212/00, G03C 1/00

(21) Application number: **88900085.7**

(22) Date of filing: **09.12.87**

(86) International application number: **PCT/JP87/00954**

(87) International publication number: **WO 88/04306 (16.06.88 88/13)**

# (54) ULTRAVIOLET-ABSORPTIVE POLYMER MATERIAL.

(30) Priority: **09.12.86 JP 291475/86**
**30.01.87 JP 19938/87**
**26.08.87 JP 211957/87**

(43) Date of publication of application: **29.11.89 Bulletin 89/48**

(45) Publication of the grant of the patent: **09.02.94 Bulletin 94/06**

(84) Designated Contracting States: **DE FR GB**

(56) References cited:
**EP-A- 190 003**
**JP-A-58 038 269**
**JP-A-58 111 942**
**JP-A-58 163 617**
**JP-A-58 178 351**
**JP-A-59 198 123**
**JP-A-60 038 411**
**JP-B-51 000 851**

(73) Proprietor: **TERUMO KABUSHIKI KAISHA**
**No. 44-1, Hatagaya 2-chome,**
**Shibuya-ku**
**Tokyo 151(JP)**

(72) Inventor: **TAKAHASHI, Toru Terumo Kabushiki Kaisha**
**2656-1, Ohbuchi**
**Fuji-shi, Shizuoka 417(JP)**
Inventor: **SHIMOMURA, Takeshi Terumo Kabushiki Kaisha**
**2656-1, Ohbuchi**
**Fuji-shi, Shizuoka 417(JP)**
Inventor: **MURAHARA, Masataka**
**935, Nikaido**
**Kamakura-shi, Kanagawa 248(JP)**

(74) Representative: **Henkel, Feiler, Hänzel & Partner**
**Möhlstrasse 37**
**D-81675 München (DE)**

**EP 0 343 246 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

Technical Field:

This invention relates to an ultraviolet-absorbing macromolecular material. More particularly, this invention relates to an ultraviolet-absorbing macromolecular material useful as the material for a high-resolution resist capable of exhibiting a high etching effect where an excimer laser is used as ultraviolet light.

Background Art:

Polymethyl methacrylate (PMMA) makes a material for photoresist featuring high resolution and, as such, has been finding extensive Utility in applications using electron beam, ultraviolet light, and X ray.

Incidentally, use of an excimer laser as a light source for processing light sensitive resin materials of this kind has been proposed recently. The term "excimer" means a dimer of an exciting atom or molecule and a ground atom or molecule. The laser of this excimer is capable of emitting an ultraviolet light of short pulses with a high output. It has been known that the excimer laser is capable of performing the one-photon or two-photon absorption reaction in an unusually short span of time as compared with the conventional photochemical reaction by the use of a mercury vapor lamp or a xenon arc lamp [Shuntaro Watanabe et al."Applied Physics," 46,978 (1977)].

Table 1 shows wavelengths generated by excimers which are formed by the combination of a varying rare gas with a varying halogen gas.

Table 1

| Combination of gases and wavelength (nm) generated | | | |
|---|---|---|---|
| | F | Cl | Br |
| Xe | 350 | 308 | 282 |
| Kr | 249 | 222 | |
| Ar | 193 | 175 | |
| F | 157 | | |

A proper laser for the photosensitization of a resin, therefore, can be selected so long as the intermolecular bond energy of the resin desired to be severed and the absorption wavelength required therefore are known. When the C-H bond of the polymethyl methacrylate resist mentioned above is to be severed by the one-photon absorption, for example, the KrF laser or an excimer laser having a shorter wavelength than the KrF laser is available. However, since the absorption region of this resin falls on a relatively short wavelength side, ranging between 195 and 230 nm, the resin exhibits high absorption to the ArF laser but low absorption to the KrF laser. Thus, the KrF laser produces a poor etching effect on this resin. In the circumstances, the feasibility of the incorporation in polymethyl methacrylate of about 10% of a heterocyclic aromatic compound (such as anthracene, acridine, phenazine, carbazole, biphenyl, or benzoin) is now being studied. It is reported that the resin so incorporating the aromatic compound therein exhibits high absorption to the KrF laser and possesses high resolution [Masataka Murahara, Yoshiyuki Kawamura, Koichi Toyota, and Susumu Namba: "Applied Physics," 52, 83(1983)]. The mere addition of the heterocyclic aromatic compound as a photosensitizer to polymethyl methacrylate has not been able to impart stable absorption characteristics to the polymethyl methacrylate because the added photosensitizer is vaporized into the ambient air when the polymer solution of polymethyl methacrylate is applied on a substrate and then subjected to baking at a temperature exceeding about 150 °C. Further, any positive type photoresist material like polymethyl methacrylate is generally required to be a high molecular substance for the purpose of acquiring high resolution and to be highly resistant to heat for the purpose of enabling the baking temperature to be heightened enough to ensure prevention of the resist from the phenomenon of sagging. None of the polymethacrylic ester type resist materials heretofore developed satisfies these requirements.

An object of this invention, therefore, is to provide an ultraviolet-absorbing macromolecular material. Another object of this invention is to provide an ultraviolet-absorbing macromolecular material exhibiting highly desirable absorption characteristics to the ultraviolet light generated by an excimer laser. A further object of this invention is to provide an ultraviolet-absorbing macromolecular material useful as a high-resolution resist material exhibiting high etching efficiency. Still another object of this invention is to provide a polymethyl methacrylate type ultraviolet-absorbing macromolecular material possessing a high absorption peak near 249 nm. Yet another object of this invention is to provide a methyl methacrylate type ultraviolet-absorbing macromolecular material possessing high resistance to heat.

Disclosure of the Invention:

The objects described above are accomplished by an ultraviolet-absorbing macromolecular material comprising

(a) a copolymer of a methacrylic ester monomer and

(b) another vinyl monomer selected from the group consisting of vinyl biphenyl, vinyl pyridine, vinyl naphthalene, N-vinyl carbazole, and mixtures thereof, possessing a chromophoric group exhibiting within the ultraviolet light wavelength region an absorption peak different from the absorption peak of said methacrylic ester, the limiting viscosity number of said copolymer being in the range of $1 \times 10^2$ to $4 \times 10^3$ (dl/g),

wherein the content of said other vinyl monomer by molar ratio relative to said methacrylic ester monomer in said polymer is in the range of 1/10 to $1/10^3$.

This invention further discloses an ultraviolet-absorbing macromolecular material, wherein the methacrylic ester is methyl methacrylate. This invention further discloses an ultraviolet-absorbing macromolecular material, wherein the absorption peak of the aforementioned other vinyl monomer falls near 249 nm. This invention further discloses a ultraviolet-absorbing macromolecular material, wherein the transmittance to a light of a wavelength near 249 nm is less than 10%. This invention further discloses an ultraviolet-absorbing macromolecular material, wherein the aforementioned copolymer has been synthesized by plasma initiated polymerization under the aid of a polymerization initiator.

Brief Description of the Drawings:

Fig. 1 a-b, Fig. 2 a-b, and Fig. 3 a-d are diagrams illustrating typical methods for plasma initiated polymerization used for the preparation of an ultraviolet-absorbing macromolecular material of the present invention. Figs. 4 through 6 and Fig. 9 are ultraviolet absorption spectra of varying ultraviolet-absorbing macromolecular materials according with the present invention. Fig. 7 is an ultraviolet absorption spectrum of polymethyl methacrylate. Fig. 8 and Fig. 10 are charts showing elution patterns of the gel permeation chromatography obtained before and after the irradiation of a ultraviolet-absorbing macromolecular material of the present invention with an excimer laser.

Best Mode for carrying out the Invention:

The ultraviolet-absorbing macromolecular material of the present invention is produced by copolymerizing a methacrylic ester monomer with other vinyl monomer possessing a chromophoric group exhibiting in the ultraviolet light wavelength region thereof an absorption peak different from the absorption peak of the methacrylic ester. The ultraviolet-absorbing macromolecular material, therefore, enjoys the high resolution inherent in the polymethacrylic ester in combination with the fact that the enhanced ultraviolet absorption characteristic is unusually stable because the action of photosensitization is effected by the other monomer incorporated in the copolymer. When the copolymer incorporates therein a compound possessing a chromophoric group exhibiting an absorption peak near 249 nm, for example, as the other vinyl monomer, the copolymer is allowed to have the initial absorbency index thereof to the light of a wavelength near 249 nm shifted to an extremely high level. Consequently, it exhibits a high etching efficiency stably when it is utilized as a photoresist using the KrF laser as the light source.

Generally, it is difficult to produced a high molecular copolymer exhibiting high resistance to heat from a methacrylic ester monomer and other vinyl monomer possessing a chromophoric group exhibiting an absorption peak different from the absorption peak of the methacrylic ester. The inventors have continued a diligent study with a view to obtaining the copolymer of this description. They have consequently found that the aforementioned copolymer can be synthesized in a high yield by modifying to some extent the conventional method of polymerization known as a plasma-initiated polymerizaiton method.

Now, the present invention will be described more specifically below with reference to embodiments of the present invention.

The ultraviolet-absorbing macromolecular material of this invention is a copolymer of a methacrylic ester monomer and other vinyl monomer possessing a chromophoric group exhibiting in the ultraviolet light wavelength region an absorption peak different from the absorption peak of the aforementioned methacrylic ester as described above. This copolymer possesses a composition such that the content of the aforementioned other monomer by molar ratio relative to the methacrylic ester monomer falls in the range of 10 : 1 to $10^3$ : 1, more desirably 10 : 1 to $10^2$ : 1. If the content of the aforementioned other monomer by molar ratio is less than $10^3$ : 1, no sufficient enhancement of the absorption characteristic is attained by the produced ultraviolet-absorbing macromolecular material. Conversely if this content in molar ratio exceeds 10 : 1, there is the possibility that the highly desirable properties including resolution and thermal stability possessed by polymethyl methacrylate will be degraded. Thus, the aforementioned range of the content of the aforementioned other vinyl monomer is important. Further, the limiting viscosity number, $\eta$ , of the aforementioned copolymer is in the range of 1 x $10^2$ to 4 x $10^3$, preferably 2 x $10^2$ to 4 x $10^3$. When the ultraviolet-absorbing macromolecular material of the present invention is made of such a macromolecular substance as described above, it automatically possesses the C-H bond of the main chain in high density. When it is used as a photoresist, for example, it exhibits further enhanced resolution because the severance of the C-H bond by the absorption energy occurs efficiently in the portion exposed to the ultraviolet light. Moreover, since the ultraviolet-absorbing macromolecular material is sufficiently resistant to heat, it can be safely treated at a very high baking temperature. This fact proves to be highly desirable particularly where the excimer laser is used as the source of exposure in respect that, though the excimer laser is capable of emitting light of high energy for a brief period of time, a failure thereof in effecting efficient severance of the C-H bond inevitably results in an increase in the number of irradiations and possibly entails a decline of the resolution because this laser is in the form of pulses.

The methacrylic ester to be used as one of the components of the copolymer is a methacrylic ester whose ester group is an alkyl group of 1 to 4 carbon atoms. Concrete examples of the methacrylic ester are methyl methacrylate, ethyl methacrylate, n-propyl methacrylate, isopropyl methacrylate, and n-butyl methacrylate. Among other methacrylic ester cited above, methyl methacryalte proves to be particularly desirable. The other vinyl monomers used in the present invention possess a chromophoric group exhibiting in the ultraviolet light wavelength region an absorption peak different from the absorption peak of the methacrylic ester. For the production of a ultraviolet-absorbing macromolecular material exhibiting strong absorption to the ultraviolet light emitted by the KrF laser, for example, a compound which has coupled to a vinyl group a chromophoric group possessing an absorption peak near 249 nm can be used. Specifically, the following vinyl monomers are used: vinyl biphenyl, vinyl pyridine, vinyl naphthalene, and N-vinyl carbazole.

The ultraviolet-absorbing macromolecular material of the present invention can be prepared easily in a high yield by the plasma initiated polymerization method using a radical polymerization initiator, which method comprises preparing a gaseous phase containing the monomers in vaporized form and permitting the presence of a radical polymerization initiator, irradiating the gaseous phase with plasma, inducting the polymerization initiation active seed generated in consequence of the plasma irradiation into the condensate phase of the monomers, thereby effecting the chain-growth polymerization of the monomers. The gaseous phase used in the polymerization method described above does not always require presence of all the monomers which are essential components of the copolymer, therefore, for example, only one of the monomers for the copolymer may be present in, so long as all the monomers exsist on the post-polymerization which is performed after the irradiation of the gaseous phase with the plasma. The presence of an alcohol in the condensate phase which is undergoing the post-polymerization contributes to shortening the time required for polymerization and further enhancing the yield of polymerization (Japanese Patent Laid-Open SHO 60(1985)-224,892).

The amount of the aforementioned other vinyl monomer to be used in the copolymerization relative to the methacrylic ester monomer is fixed based on the composition of the copolymer desired to be obtained. For the purpose of increasing the yield of polymerization, the content of the other vinyl monomer by molar ratio relative to the methacrylic ester monomer, the methacrylic ester monomer: the other vinyl monomer, is in the range of 10 : 1 to $10^3$ : 1. In the aforementioned copolymer of which the ultraviolet-absorbing macromolecular material of this invention is made, the aforementioned other monomer component is not always required to be a sole compound but may be mixture of two or more compounds.

As the radical polymerization initiator to be used in the aforementioned plasma polymerization method, there can be used any of the conventional radical polymerization initiators which are available for the radical polymerization of monomers. Examples of the radical polymerization initiator are such low-temperature active radical polymerization initiators as peroxides represented by acetylcyclohexyl sulfonyl peroxide, isobutyryl peroxide, cumyl-peroxy neodecanoate, diisopropyl-peroxy dicarbonate, di-n-propyl-peroxy dicarbonate, dicyclohexyl-peroxy dicarbonate, dimylistyl-peroxy dicarbonate, di-(2-ethoxyethyl)-peroxy dicarbonate, di-(methoxyisopropyl) -peroxy-dicarbonate, di-(2-ethylhexyl)-peroxy dicarbonate, di-(3-methyl-3-methoxybutyl)-peroxy dicarbonate, t-butyl-peroxy neodecanoate, potasium persulfate, and ammonium persulfate, and azo compounds represented by 2,2'-azobis-(4-methoxy-2,4-dimethyl-valeronitrile) and 2.2' -azobis- (2,4-dimethyl-valeronitrile) and 2,4-azobis-(2,4-dimethyl-valeronitrile) and such high temperature active radical polymerizaiton initiator as peroxides represented by t-butyl-cumyl peroxide, diisopropylbenzene hydroperoxide, di-t-butyl peroxide, p-methane hydroperoxide, 2,5-dimethyl-2,5-di-(t-butyl-peroxy)-hexine-3, 1,1,3,3-tetramethylbutyl hydroperoxide, 2,5-dimethylhexane-2,5-dihydroperoxide, cumene hydroperoxide, t-butyl hydroperoxide, 1,1-bis (t-butyl-peroxy)-3,3,5-trimethyl cyclohexane, 1,1-bis(t-butyl-peroxy) cyclohexane, t-butyl-peroxy maleate, t-butyl-peroxy laurate, t-butyl peroxy-3,5,5-trimethyl hexanoate, t-butyl-peroxy-2-ethyl hexanoate, cyclohexanone peroxide, t-butyl-peroxy isopropyl carbonate, 2,5-dimethyl-2,5-di-(benzoyl-peroxy) hexane, 2,2-bis(t-butyl-peroxy)octane, t-butyl-peroxy acetate, 2,2-bis(t-butyl-peroxy) butane, t-butyl-peroxy benzoate, n-butyl-4,4-bis(t-butyl-peroxy) valeate, di-t-butyl-diperoxy isophthalate, methylethyl ketone peroxide, $\alpha$ , $\alpha'$ - -bis(t-butyl-peroxy-isopropyl) benzene, dicumyl peroxide, 2,5-dimethyl-2,5-di(t-butyl-peroxy) hexane, t-butyl hydroperoxide, m-toluoyl peroxide, benzoyl peroxide, t-butyl-peroxy isobutyrate, octanoyl peroxide, decanoyl peroxide, lauroyl peroxide, stearoyl peroxide, propionyl peroxide, and succinic acid peroxide and azo compounds represented by 1,1'-azobis-(cyclohexane-1-carbonitrile) and azobis-isobutyronitrile. The low-temperature active radical polymerizaiton initiators require decomposition temperatures of not more than 50 °C in obtaining a half-life of 10 hours, whereas the high-temperature active radical polymerizaiton initiators require decomposition temeperatures approximately in the range of 60 ° to 220 °C in obtaining the half-life of 10 hours.

The amount of the radical polymerization initiator to be added to the monomers depends heavily on the polymerizaiton degree of the polymer to be obtained and on the kinds of the monomers and the radical polymerization initiator to be used. Thus, it cannot be generally defined. The addition of the radical polymerization initiator in an unduly large amount, however, proves to be undesirable because the radical polymerization initiator is not completely spent out during the course of the polymerization but suffered to remain in the produced polymer. In the production of methyl methacrylate-4-vinyl biphenyl copolymer possessing a limiting viscosity number, $\eta$ , on the order of $10^2$, for example, benzoyl peroxide (BPO) is used in an amount in the range of $4 \times 10^{-5}$ to $2 \times 10^{-2}$ mol/liter or azobis-isobutyronitrile (AIBN) in an amount in the range of $6 \times 10^{-5}$ to $6 \times 10^{-3}$ mol/liter.

The plasma to be used in the aforementioned plasma-initiated polymerization method is nonequilibrium plasma, particularly a low-temperature plasma by glow discharge. This low-temperature plasma is obtained by applying a power in the range of 20 to 100 W, preferably 30 to 50 W, upon a gas held under a vacuum as in the range of 0.1 to 10 mmHg. The electrodes to be used for the generation of this plasma are externally or internally parallel planar electrodes or coil electrodes for example. Preferably, they are externally parallel planar electrodes. Any gas may be used as the source for plasma generation. Examples of the gas include hydrogen, methane, nitrogen, argon, and ethylene. The monomers in the gaseous form may be used when desired.

In the plasma-initiated polymerization method, generally as illustrated in Fig. 1 a-b, during the course of the plasma irradiation, the condensate phase 1 of monomer and the gaseous phase 2 of monomer are held in an equilibrium state within a container 4 without being separated from each other as with a partition. When the gaseous phase 2 is irradiated with the plasma, it gives rise to a polymerization active seed. When this active seed comes into contact with the surface of the solid phase, the post-polymerization is initiated. As well known in the art, the plasma-initiated polymerization method can be otherwise carried out, as illustrated in Fig. 2 a-b, by keeping the condensate phase 1 of monomer and the gaseous phase 2 of monomer separated from each other with a partition 3 prior to the irradiation with the plasma, irradiating the gaseous phase 2 with the plasma, then removing the partition 3 thereby allowing the gaseous phase 2 now containing the polymerization active seed into contact with the condensate phase 1, and initiating the post-polymerization by virtue of the contact of polymerization active seed with the condensate phase 1 or, as illustrated in Fig. 3 a-d, by keeping the gaseous phase 2 containing the monomer vapors sealed in a plasma reaction vessel 4 prior to the irradiation with the plasma, irradiating the reaction vessel with the plasma, then allowing the gaseous phase 2 to depart from the reaction vessel 4 into the ambient air, subsequently sealing freshly supplied monomers in the reaction vessel 4 which has undergone the irradiation with the plasma, and effecting the post-polymerization in the condensate phase 1. All these procedures are usable for the polymerization contemplated because, even during the course of the plasma initiated polymerization, the macromolecular material is applied in the form of a coating of extremely small thickness on the surface of the plasma reaction vessel 4 made of such material as glass and the polymerization active seed in caught fast by the matrix structure of the macromolecular substance or because the finely divided plasma polymerised macromolecular substance keeping firm hold of the polymerization active seed is present in the gaseous phase 2 (Masayuki Kuzutani: "Mechanism of Plasma-initiated Polymerization," glossary of manuscripts for Plasma Chemistry Symposium, November 14, 1984).

When the plasma-initiated polymerization method is carried out by the procedure illustrated in Fig. 1 a-b or Fig. 3 a-d, the material of the plasma reaction vessel 4 used for the polymerization is desired to be glass such as quartz glass or Pyrex glass to permit the surface thereof to be coated effectively with the aforementioned extremely thin layer of the macromolecular substance. Use of Pyrex glass proves to be particularly desirable.

In the diagrams of Fig. 1a, Fig. 2a, and Fig. 3a, the reference numeral 5 denots an electrode, the reference numeral 6 an RF oscillator, and the reference numeral 7 a control unit.

The irradiation of the gaseous phase 2 with the plasma is carried out at a temperature at which the monomers in vaporized form can exist in the gaseous phase 2 held in a vacuum. Generally, this temperature falls in the neighborhood of room temperature. The time of irradiation is not specifically limited. For effective formation of the polymerization active seed, however, the irradiation time may be short, generally falling in the range of several seconds to several minutes. The post-polymerization in the condensate phase 1 is carried out in the neighborhood of room temperature. This temperature, however, hinges more or less on the kind of the radical polymerization initiator, for example. Such a low temperature as described above is desirable because the post-polymerization, when carried out at an unduly high temperature, proceeds after the pattern of thermal polymerization and consequently gives rise to a polymer of low polymerization degree. An unduly low temperature proves to be undesirable because the polymerization possibly fails to proceed smoothly. When a low-temperature active radical polymerization initiator is used, the post-polymerization in the solid phase proceeds sufficiently even in such a low temperature range as 0° to -20°C, in which the post-polymerization would be hardly carried out by the conventional plasma-initiated polymerizaiton method.

The adjustment of the polymerization degree of the polymer obtained by the plasma-initiated polymerization method can be attained by allowing the polymerization active seed which is obtained by the plasma irradiation to be generated in a theoretical amount.

As examples of the alcohol which is added as described above to the reaction system, there can be cited alcohols of 1 to 10 carbon atoms such as methanol, ethanol, n-propanol, isopropanol, n-butanol, sec-butanol, n-amyl alcohol, isoamyl alcohol, hexanol, heptanol, octanol, capryl alcohol, nonyl alcohol, and decyl alcohol. Among alcohols enumerated above, lower alcohols, particularly methanol, prove to be desirable. During the course of the plasma irradiation, this alcohol may or may not be present in the gaseous phase.

Since the ultraviolet-absorbing macromolecular material of the present invention obtained as described above possesses highly desirably ultraviolet absorption characteristic, it can be used advantageously as photoresists and various forms of resists in the production of printing plates; shadow masks in color TV cathode ray tubes, printed circuit boards, IC, LSI or ultra LSI's circuits, circuits LP records, master video discs, metal filters, and electronic razor blades in the electronic industry; master discs for nitric acid etching in the glass and ceramic industry; part circuits for watches and cameras in the precision machinery industry; and holographic gratings for laser holograms. As the source of light for irradiation of the ultraviolet-absorbing macromolecular material of the present invention, the light of wavelength of not more than 350 nm, preferably an excimer laser, can be used. By reason of the ability to cut the C-H bond by the one-photon absorption, the excimer laser is desired to be KrF laser (249nm), or KrCl (222 nm), ArF (193 nm), ArCl (175 nm), or $F_2$ (157 nm) laser, being in shorter wavelength resion than KrF. Particularly when the aforementioned other monomer is a vinyl monomer such as vinyl biphenyl, vinyl pyridine, vinyl naphthalene, or N-vinyl carbazole which possesses an aromatic ring or a heterocyclic aromatic ring as a chromophoric group exhibiting an absorption peak near 249 nm, it is desirable to use the excimer laser (KrF) because ultraviolet-absorbing macromolecular material exhibits a low transmittance, preferably a transmittance of not more than 10%, to the light of wavelength near 249 nm. Thus, the ultraviolet-absorbing macromolecular material can be offered as a resist featuring high resolution and high etching efficiency.

In the production of a resist with the ultraviolet-absorbing macromolecular material of the present invention, a high-resolution resist can be advantageously formed by causing the ultraviolet-absorbing macromolecular material to be applied by the spin coat technique in a thickness of not more than 1μm, preferably not more than 0.3μm, on a substrate such as a wafer of silicone or a mixture using silicone as one component, or a quartz sheet. Even when the ultraviolet-absorbing macromolecular material of this invention is applied in a thickness of not more than 1 μm, the coating consequently obtained is free from such defects as pinholes because it is made of a macromolecular substance. The resist which is obtained as described above can be thoroughly etched by one to several irradiations with the excimer laser.

Now, the present invention will be described more specifically below with reference to working examples. These examples are cited purely for the purpose of aiding in the illustrating of the invention and are not meant to limit the scope of this invention at all.

Example 1

A polymerization tube (42 ml in volume) of Pyrex glass having an inside diameter of 15 mm was charged with 5.34 ml (5.00 x $10^{-2}$ mol) of methyl methacrylate (MMA), 0.90 g (5.00 x $10^{-3}$ mol) of 4-vinyl biphenyl, and 0.005 g (4.13 x $10^{-3}$ mol/ℓ) of benzoyl peroxide (BPO), connected to a vacuum line, and then frozen with liquefied nitrogen. This polymerization system was evacuated to as level below $10^{-3}$ Torr for thorough expulsion of oxygen and heated to remelt the contents thereof. This procedure was repeated three times. With the cock closed, the monomers in the polymerization tube were thoroughly cooled and frozen again with liquefied nitrogen. At the time that part of the monomers in the polymerization tube began to dissolve near normal room temperature, plasma was generated in the gaseous phase. The electrodes used for the plasma generation were parallel planar electrodes 15.0 x 10.0 $cm^2$ in surface area made of copper and separated by a distance of 18 mm. On these electrodes, a power of 50 W fed out from a radio wave (RF) generator provided with a control unit capable of 13.56 MHz was applied. The irradiation with the plasma was continued for 60 seconds. After the irradiation with the plasma, the polymerization tube was sealed and left standing at rest at 25°C for 5 days for post-polymerization. The polymerization product consequently obtained was purified by being dissolved in 30 ml of benzene and reprecipitated in 1.0 liter of methanol, and then filtered. The polymerization product was vacuum dried at 80°C to produced white fibers of polymer. The weight of the polymer was 0.88 g and the yield thereof 15.8% by weight. The melting point of this polymer was 235.5° to 240.0°C. The limiting viscosity number of this polymer measured in benzene at 30°C was 1.65 x $10^2$. The average molecualr weight of this polymer calculated based on the Mark Houwink equation, $\eta = KM^{\alpha}$, using the limiting viscosity number and the coefficients K = 5.2 x $10^{-3}$ and $\alpha$ = 0.76, proper for polymethyl methacrylate, was about 8.375 x $10^5$.

To determined the absorption characteristic of the produced polymer, the polymer was dissolved in a concentration of 1 w/v % in chloroform, the resultant solution was cast on a Teflon plate to produce a film 3 µm in thickness, and the film was treated to obtain an ultraviolet absorption spectrum. The results are shown in Fig. 4.

It is noted from the results that the trasmittance of the film on the short wavelength side below 300 nm was nearly 0%, evincing that the polymer was highly capable of absorbing ultraviolet light.

In consideration of the results, the copolymer was dissolved in a concentration of 1% by weight in methyl isobutyl ketone and the resultant solution was applied on a quartz plate (2 cm x 2cm) in such an amount that, after baking at 170°C for 30 minutes, there was formed a film about 1µm in thickness. When this film was irradiated with KrF (249 nm) laser (an interferential KrF laser beam [100 mJ/$cm^2$] having the diverging angle of beam fixed at 0.4 Mrad) generated with a laser system (produced by Tachsto Laser Systems Inc., and marketed under product code of "SOlXR") and projected through a slit (1.0 mm in width) (1 pulse: 10 nanoseconds), a non-developed etching could be attained with 1 pulse of irradiation with high resolution (minimum line width 0.5 µm).

Example 2

A copolymer 0.18 g in amount was obtained in a yield of 15.2% by repeating the procedure of Example 1, except that the molar ratio of methyl methacrylate monomer to 4-vinyl biphenyl was changed to 30 : 1. The limiting viscosity number, $\eta$, of this polymer was 3.561 x $10^2$ and the viscosity average molecular weight thereof was about 2.305 x $10^6$. When this copolymer was examined with respect to absorption characteristic, the transmittance thereof on the short wavelength side below 300 nm was found to be nearly 0%, indicating the copolymer to be a material highly capable of absorbing ultraviolet light. When at film of this copolymer was irradiated with the same KrF laser as in Example 1, it could be etched with 1 pulse.

Referential Experiments 1 through 4

Copolymers were obtained by repeating the procedure of Example 1, except that the molar ratio of methyl methacrylate monomer to 4-vinyl biphenyl was varied as shown in Table 2. When the copolymers were tested for absorption characteristic at 249 nm, the results were as shown in Table 2. When films of the copolymers were irradiated with the same KrF laser as in Example 1, they could not attain non-developed etching unless the irradiation was made with at least 10 pulses (dosage 1,000 mJ/$cm^2$).

Table 2

| Referential Experiment | Molar ratio methyl methacrylate: 4-vinyl biphenyl | Amount produced (g) | Yield of product (%) | [ η] | Mv* | Transmittance to Ultraviolet light (249 nm) (%) |
|---|---|---|---|---|---|---|
| 1 | 60 : 1 | 0.60 | 24.0 | $9.24 \times 10^2$ | $8.08 \times 10^6$ | 1.4 |
| 2 | 70 : 1 | 2.40 | 37.9 | $9.74 \times 10^2$ | $8.66 \times 10^6$ | 5 |
| 3 | 80 : 1 | 1.82 | 75.2 | $1.02 \times 10^3$ | $9.23 \times 10^6$ | 17 |
| 4 | 90 : 1 | 1.96 | 79.0 | $1.07 \times 10^3$ | $9.81 \times 10^6$ | 44 |

*Mv was calculated based on the equation, $[\eta] = KM^{\alpha}$ , using the coefficients,

$K = 5.2 \times 10^{-3}$ and $\alpha = 0.76$, proper to methyl methacrylate.

Example 3

A white polymer was obtained by polymerization following the procedure of Example 1, except that 0.97 g ($5.0 \times 10^{-3}$ mol) of N-vinyl carbazole was used in the place of 4- vinyl biphenyl. The polymer was 4.61 g in amount and the yield of this product was 76.2% by weight. The melting point of this polymer was 275.5° to 295.5°C and the limiting viscosity number, $\eta$, thereof, measured in the same manner as in Example 1, was 5.28 x $10^2$. When the ultraviolet absorption spectrum of this polymer was examined in the same way as in Example 1, the transmittance thereof on the short wavelength side below 300 nm was nearly 0 as shown in Fig. 5, indicating the polymer to be a material highly capable of absorbing ultraviolet light.

Example 4

A yellow rubbery polymer was obtained by polymerization following the procedure of Example 1, except that 0.54 ml of 2-vinyl pyridine was used in the place of 4-vinyl biphenyl. The weight of the polymer was 0.33 g and the yield of the product was 6.0% by weight. The melting point of this polymer was 168.5° to 193.5°C and the limiting viscosity number, $\eta$, thereof as measured in the same manner as in Example 1 was 9.95 x $10^1$. When the ultraviolet absorption spectrum of this polymer was examined in the same way as in Example 1, the transmittance thereof near 249 nm was nearly 0% as shown in Fig. 6.

Control 1

In a polymerization tube, 15.0 ml (5.0 x $10^{-2}$ mol) of methyl methacrylate and 0.015 g (4.17 x $10^{-3}$ mol/ℓ) of benzoyl peroxide were subjected to polymerization by following the procedure of Example 1, to produce a white powdery polymer. The weight of the polymer was 11.33 g and the yield of this product was 80.7%. The melting point of this polymer was 278.0° to 295.0°C. The limiting viscosity number, $\eta$, of the polymer, measured in the same manner as in Example 1, was 1.75 x $10^3$. When the ultraviolet absorption spectrum of this polymer was examined in the same way in Example 1, the transmittance thereof near 249 nm was found to be about 95% as shown in Fig. 7.

Example 5

A polymerization tube (42 ml in inner volume) of Pyrex glass having an inside diameter of 15 mm was charged with 10.68 ml (1.00 x $10^{-1}$ mol) of methyl methacrylate, 0.30 g (1.66 x $10^{-3}$ mol) of 4-vinyl biphenyl, and 0.011 g (4.13 x $10^{-3}$ mol/ ℓ) of benzoyl peroxide, connected to a vacuum line, and frozen with liquefied nitrogen. This polymerization system was evacuated to a level of not more than $10^{-3}$ Torr for thorough expulsion of oxygen and left warming to remelt the contents thereof. This procedure was repeated three the contents thereof. This procedure was repeated three times. With the cock closed, the monomers in the polymerization tube was thoroughly cooled and frozen again wtih liquefied nitrogen. At the time that part of the monomers in the polymerization tube began to melt at room temperature, a plasma was generated in the gaseous phase. The electrodes used for the plasma generation were parallel planar electrodes 15.0 cm x 10.0 cm in area made of copper and separated by a distance of 18 mm. On these electrodes was applied a power of 50 W fed out from a radio wave generator (RF) provided with a control unit of 13.56 MHz. The time for the irradiation with the plasma was 60 seconds. After the irradiation with the plasma, the polymerization tube was sealed and left standing at rest at 25°C for 5 days to effect post-polymerization of the contents thereof. The polymerization product consequently obtained was purified by being dissolved in 1.0 liter of benzene, reprecipitated in 20.0 liters of methanol, and filtered. The purified polymerization product was vacuum dried at 80°C to produce white polymer fibers. The weight of the produced polymer was 8.02 g and the yield of the product was 78.3 % by weight. The melting point of this polymer was 259.5° to 264.8°C. The limiting viscosity number, $\eta$, of the polymer measured in benzene at 30°C was 9.52 x $10^2$. The average molecular weight of this polymer calculated based on the Mark-Houwink equation, $\eta = KM^\alpha$, using the coefficients K = 5.2 x $10^{-3}$ and $\alpha$ = 0.76, proper to polymethyl methacrylate was about 8.41 x $10^6$. By elementary analysis, the polymer was found to be a copolymer composed of 99.72 mol% of methyl methacrylate and 0.28 mol% of 4-vinylbiphenyl fluoride.

The polymer was dissolved in a concentration of 1% by weight in methyl isobutyl ketone. The resultant solution was applied with a spin coater (produced by Mikasa Co., Ltd. and marketed under trademark designation of "Spinner Model IH-D2")in a thickness of 300 nm on a silicon wafer 4 inches in diameter and baked at 170°C for 30 minutes. The entire surface of the silicon wafer coated with a the film of the copolymer was irradiated 11 times with a KrF (249 nm) laser (an interferential KrF laser beam [90 mJ/$cm^2$], with the diverging angle of beam fixed at 0.4 Mrad) generated with a laser system (produced by Tachsto Laser Systems Inc., and marketed under product code of "SOIXR") and projected through a slit (1.0 mm in width). After this irradiation, the film was removed from the silicon wafer and tested by gel permeation chromatograph (GPC) for average molecular weight and molecular weight distribution. The results were compared with those obtained before the irradiation. The gel permeation chromatography was carried out by an apparatus combining a chromatogram (produced by Nippon Bunko Co., Ltd. and marketed under trademark designation of "TRIROTAR VI") with columns (produced by Toyo Soda Mfg Co., Ltd. and marketed under product codes of "G700HXL" and "GMH6"). The results are shown in Table 3 and Fig. 8.

As shown in Table 3 and Fig. 8, the molecular weight (weight average molecular weight $6.45 \times 10^6$) before the irradiation with the excimer laser markedly fell to a weight average molecular weight of $1.50 \times 10^4$ in consequence of the irradiation, evincing that the irradiation with the excimer induced decomposition of the polymer and suggesting usefulness of the film as a positive type resist. When the film was subjected to a developing treatment, it was found that the molecular weight (before the irradiation with the laser) fell in proportion as the baking temperature rose from 90° to 230°C. The developing time was not found to vary with the baking temperature. It was consequently confirmed that the desirability of the contrast of developed image increased with the increasing baking temperature.

Example 6

Polymerization was carried out by following the procedure of Example 5, except that a polymerization tube (42 ml in inner volume) of Pyrex glass having an inside diameter of 15 mm was charged with 2.67 ml ($2.50 \times 10^{-2}$ mol) of methyl methacrylate (MMA), 0.064 g ($4.17 \times 10^{-4}$ mol) of 2-vinyl naphthalene, and 0.003 g ($4.13 \times 10^{-3}$ mol ) of benzoyl peroxide (BPO). The weight of the produced polymer was 2.05 g and the yield of this product was 79.7% by weight. The melting point of this polymer was 259.5° to 265.5°C and the limiting viscosity number, $\eta$ , of the polymer measured in benzene at 30°C was $5.97 \times 10^2$. The average molecular weight of the polymer calculated based on the Mark-Houwink equation, $\eta = KM^\alpha$ , using the coefficients, $K = 5.2 \times 10^{-3}$ and $\alpha = 0.76$, proper to methyl methacrylate was found to be about $4.55 \times 10^6$.

A resist was produced from the polymer in the same manner as in Example 5. The ultraviolet absorption spectrum of this resist is shown in Fig. 9. The resist was tested for average molecular weight and molecular weight distribution by the gel permeation chromatography before and after the irradiation with the KrF laser. The results are shown in Table 3 and Fig. 10. The resolution was not more than 0.5µm of minimum line width.

As shown in Table 3 and Fig. 10, the molecular weight (weight average molecualr weight of $4.23 \times 10^6$) of the resist before the irradiation with the excimer laser markedly fell to a weight average molecular weight of $1.40 \times 10^4$ in consequence of the irradiation, indicating that the irradiation with the excimer laser induced decomposition of the polymer and suggesting usefulness of the polymer as a positive resist similarly to the polymer Example 5. These desirable results may be logically explained by a supposition that the resist acquired very high absorbency index relative to the light of wavelength near 249 nm in consequence of the copolymerizaiton of 2-vinyl naphthalene and, at the same time, enjoyed the transmittance inherent in itself (Fig. 9) and, as the result, permitted the ultraviolet light to reach a fairly large depth thereof without absorbing the light only in the surface region thereof. It was confirmed that the molecular weight (before the irradiation with the laser) decreased as the baking temperature rose from 90°C to 230°C, It was further confirmed that the time for development increased (or the strength of rest enhanced) in consequence of the baking treatment.

Table 3

| | Weight average molecular weight | |
|---|---|---|
| | Before irradiation | After irradiation |
| Example 5 | $6.45 \times 10^6$ | $1.50 \times 10^4$ |
| Example 6 | $4.23 \times 10^6$ | $1.40 \times 10^4$ |

| | Molecular weight distribution | |
|---|---|---|
| | Before irradiation | After irradiation |
| Example 5 | 4.25 | 2.33 |
| Example 6 | 5.02 | 2.50 |

Industrial Applicability:

As described above, this invention is directed to a ultraviolet-absorbing macromolecular material which is made of a copolymer of a methacrylic ester monomer and other vinyl monomer possessing a chromophoric group exhibiting in the ultraviolet light wavelength region an absorption peak different from the absorption peak of the methacrylic ester, and possessing such an extremely large molecular weight that the limiting viscosity number, $\eta$ , of the aforementioned copolymer falls in the rane of $1 \times 10^2$ to $4 \times 10^3$ (molecular weight $4.33 \times 10^5$ to $5.56 \times 10^7$). The ultraviolet-absorbing macromolecular material, therefore, possess highly desirable ultraviolet absorption characteristic, namely extremely low transmittacne to the ultraviolet light, and at the same time enjoys the outstanding resolution inherent in the polymethacrylate. It, therefore, can be utilized advantageously as various forms of resists operable with the light of near-ultraviolet or ultraviolet region and is capable of contributing greatly to a wide variety of industrial activities, represented by the printing plate industry, electronic industry, glass and ceramic industry, and precision machinery industry. Further it acquires desirable resolution and high resistance to heat and, therefore, makes a highly desirable resist. Particularly when the ultraviolet-absorbing macromolecular material of this invention is produced by using as the methacrylic ester component a methacrylic ester whose ester group is an alkyl group of 1 to 4 carbon atoms, preferably methyl methacrylate and the other vinyl monomer component is a vinyl monomer possessing a chromophoric group exhibiting an absorption peak near 249 nm, selected from the group consisting of vinyl biphenyl, vinyl pyridine, vinyl naphthalene, and N-vinyl carbazole, it acquires extremely high absorbency index or extremely low transmittance with respect to the light of wavelength near 249 nm. When this ultraviolet-absorbing macromolecular material is used as a resist destined to be operated with the KrF laser, an excimer laser, as the light source, it is enabled to acquire highly desirable resolution and exhibit high etching efficiency stably.

**Claims**

**1.** An ultraviolet-absorbing macromolecular material comprising

(a) a copolymer of a methacrylic ester monomer whose ester group is an alkyl group of 1 to 4 carbon atoms and

(b) another vinyl monomer selected from the group consisting of vinyl biphenyl, vinyl pyridine, vinyl naphthalene, N-vinyl carbazole, and mixtures thereof, possessing a chromophoric group exhibiting within the ultraviolet light wavelength region an absorption peak different from the absorption peak of said methacrylic ester, the limiting viscosity number of said copolymer being in the range of $1 \times 10^2$ to $4 \times 10^3$ (dl/g),

wherein the content of said other vinyl monomer by molar ratio relative to said methacrylic ester monomer in said polymer is in the range of 1/10 to $1/10^3$.

2. An ultraviolet-absorbing macromolecular material according to Claim 1, wherein said methacrylic ester is methyl methacrylate.

3. An ultraviolet-absorbing macromolecular material according to Claim 1, wherein the absorption peak of the chromophoric group of said other vinyl monomer falls near 249nm.

4. An ultraviolet-absorbing macromolecular material according to Claim 1, wherein the transmittance relative to the light of wavelength near 249 nm is not more than 10%.

5. An ultraviolet-absorbing macromolecular material according to Claim 1, wherein said copolymer is synthesized by plasma initiated polymerization under the aid of a polymerization initiator.

6. A photoresist, formed with an ultraviolet-absorbing macromolecular material according to Claim 1.

7. A photoresist according to Claim 6, wherein an excimer laser is used as the source of exposure.

## Patentansprüche

1. UV-absorbierendes makromolekulares Material, umfassend
   (a) ein Copolymer eines Methacrylsäureestermonomeren, dessen Estergruppe aus einer Alkylgruppe mit 1 bis 4 Kohlenstoffatom(en) besteht und
   (b) ein weiteres Vinylmonomeres, ausgewählt aus der Gruppe Vinylbiphenyl, Vinylpyridin, Vinylnaphthalin, N-Vinylcarbazol und Mischungen hiervon, mit einer chromophoren Gruppe, die innerhalb des Wellenlängenbereichs von UV-Licht einen Absorptionspeak aufweist, der sich vom Absorptionspeak des Methacrylsäureesters unterscheidet,
   wobei die Grenzviskositätszahl des Copolymeren im Bereich von 1 x $10^2$ bis 4 x $10^3$ (dl/g) liegt und wobei der Molverhältnisanteil des anderen Vinylmonomeren in bezug auf das Methacrylsäureestermonomere in dem Polymer im Bereich von 1/10 bis 1/$10^3$ liegt.

2. UV-absorbierendes makromolekulares Material nach Anspruch 1, wobei der Methacrylsäureester aus Methylmethacrylat besteht.

3. UV-absorbierendes makromolekulares Material nach Anspruch 1, wobei der Absorptionspeak der chromophoren Gruppe des anderen Vinylmonomeren nahe 249 nm liegt.

4. UV-absorbierendes makromolekulares Material nach Anspruch 1, wobei die Durchlässigkeit in bezug auf Licht einer Wellenlänge nahe 249 nm nicht mehr als 10% beträgt.

5. UV-absorbierendes makromolekulares Material nach Anspruch 1, wobei das Copolymer durch plasmainitiierte Polymerisation unter Mithilfe eines Polymerisationsanspringmittels synthetisiert wurde.

6. Photoresist, hergestellt mit einem UV-absorbierenden makromolekularen Material nach Anspruch 1.

7. Photoresist nach Anspruch 6, wobei als Belichtungsquelle ein Excimerlaser verwendet wird.

## Revendications

1. Matériau macromoléculaire absorbant les ultraviolets, comprenant:
   (a) un copolymère d'un ester méthacrylique du type méthacrylate d'alkyle à 1 à 4 atomes de carbone, et
   (b) un autre monomère vinylique choisi dans le groupe constitué du vinylbiphényle, de la vinylpyridine, du vinylnaphtalène, du N-vinyl carbazole et de leurs mélanges, possédant un groupe chromophore donnant lieu, dans le domaine des ultraviolets de faible longueur d'onde, à un pic d'absorption différent du pic d'absorption dudit ester méthacrylique, l'indice limite de viscosité dudit copolymère étant dans le domaine compris entre $1.10^2$ et $4.10^3$ dl/g,
   dans lequel la quantité dudit autre monomère vinylique en rapport molaire par rapport audit monomère ester méthacrylique, est compris entre 1/10 et 1/$10^3$.

2. Matériau macromoléculaire absorbant les ultraviolets selon la revendication 1, où ledit ester méthacrylique est le méthacrylate de méthyle.

3. Matériau macromoléculaire absorbant les ultraviolets selon la revendication 1, pour lequel le pic d'absorption du groupe chromophore dudit autre monomère vinylique se situe à proximité de 249 nm.

4. Matériau macromoléculaire absorbant les ultraviolets selon la revendication 1, dans lequel la transmittance relative à la lumière de longueur d'onde proche de 249 nm ne dépasse pas 10%.

5. Matériau macromoléculaire absorbant les ultraviolets selon la revendication 1, où ledit copolymère est synthétisé par polymérisation amorcée par plasma avec l'aide d'amorceurs de polymérisation.

6. Photoresist formé à partir du matériau macromoléculaire absorbant les ultraviolets, selon la revendication 1.

7. Photoresist selon la revendication 6, dans lequel un laser à excimère est utilisé comme source d'exposition.

FIG.1

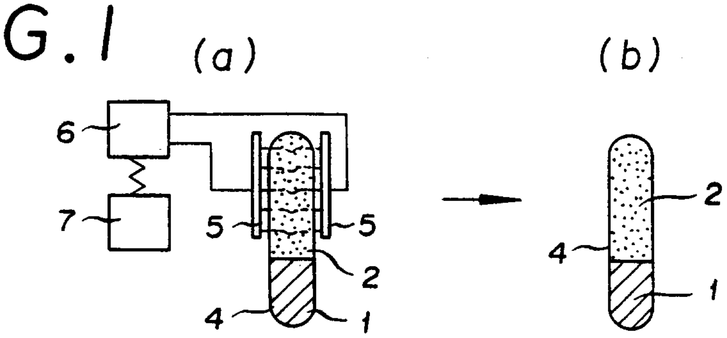


FIG.2

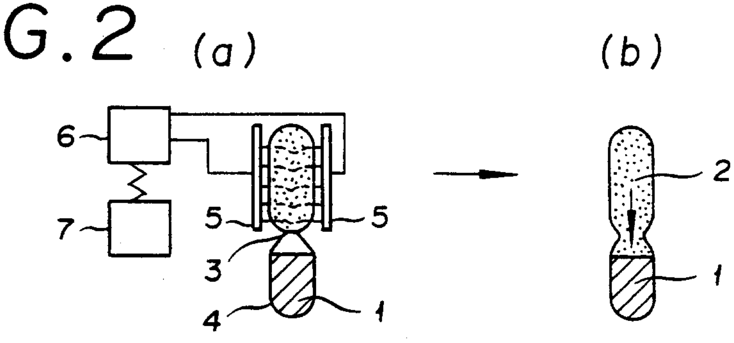


FIG.3

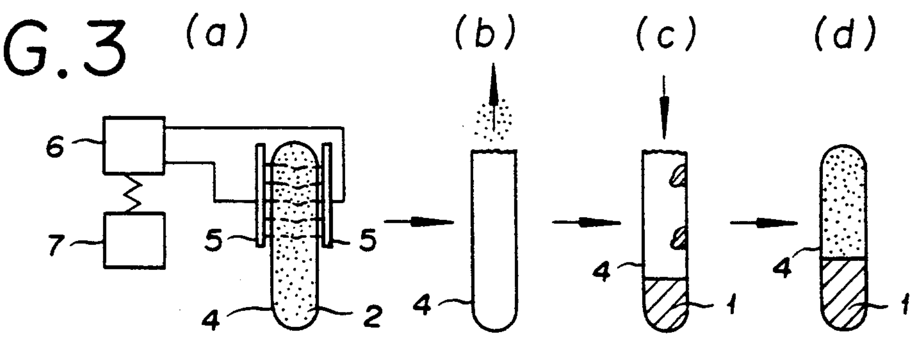

FIG. 4

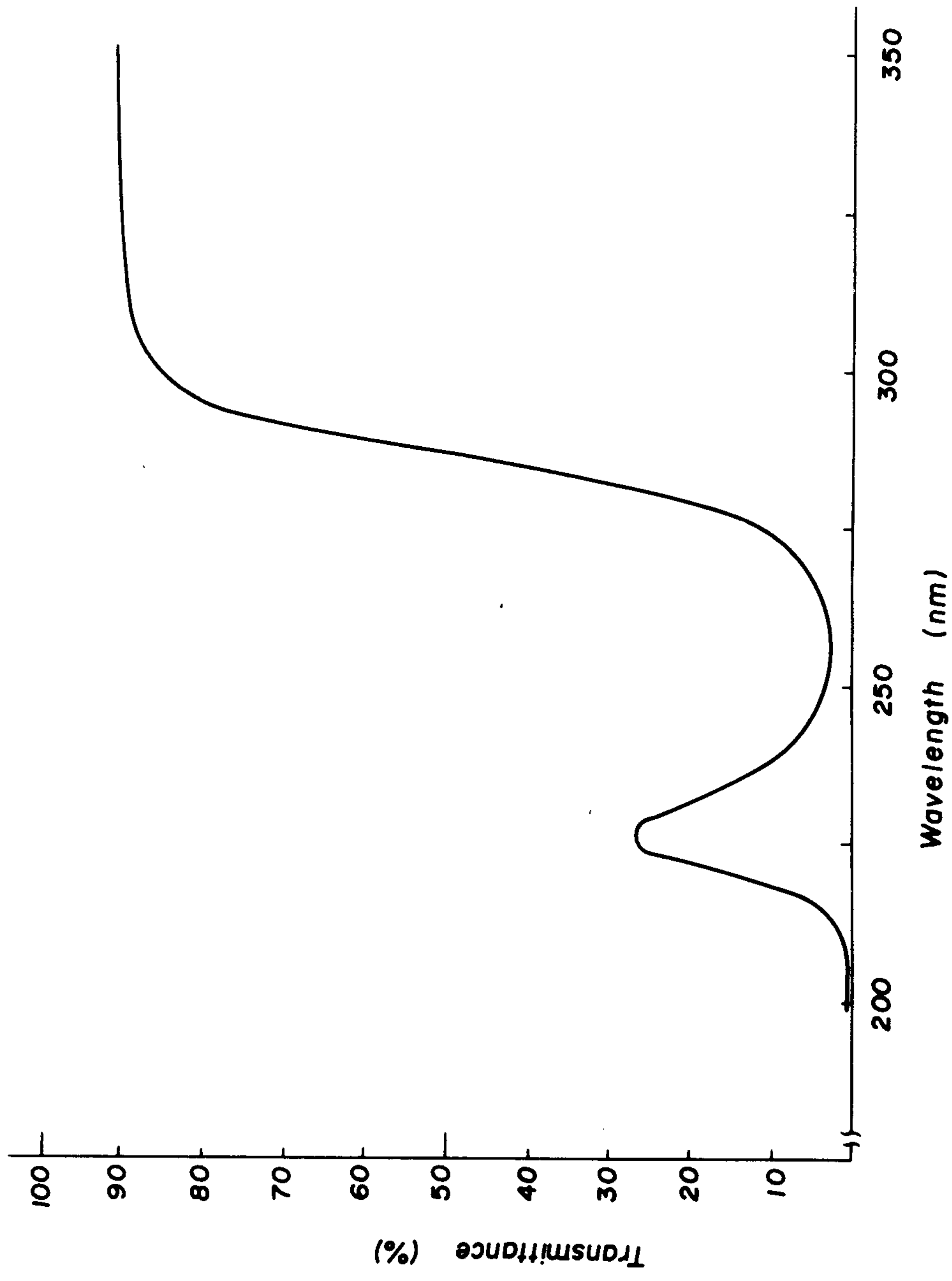

Transmittance (%)
100
90
80
70
60
50
40
30
20
10
200
250
300
350
Wavelength (nm)

FIG. 5

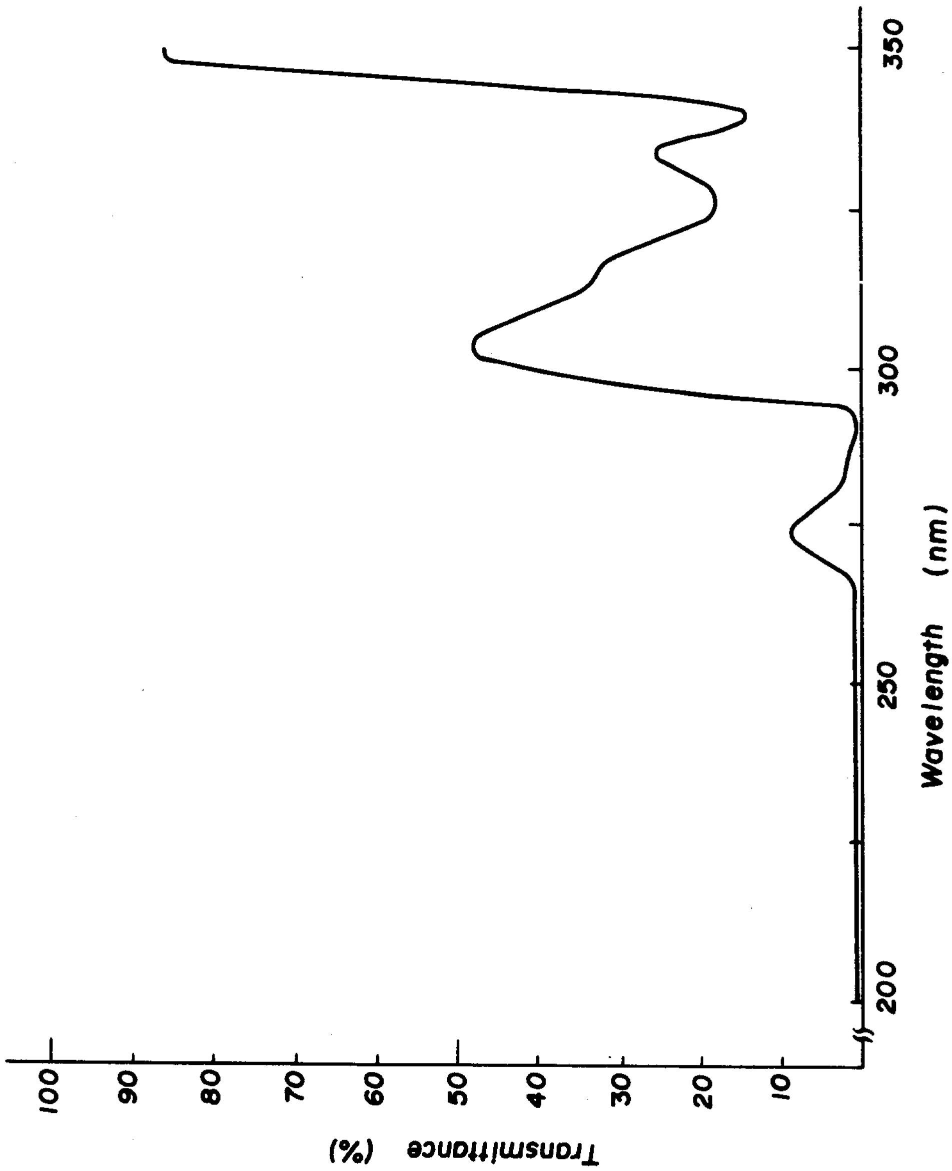
Transmittance (%)
100
90
80
70
60
50
40
30
20
10
200
250
300
350
Wavelength (nm)

FIG.6

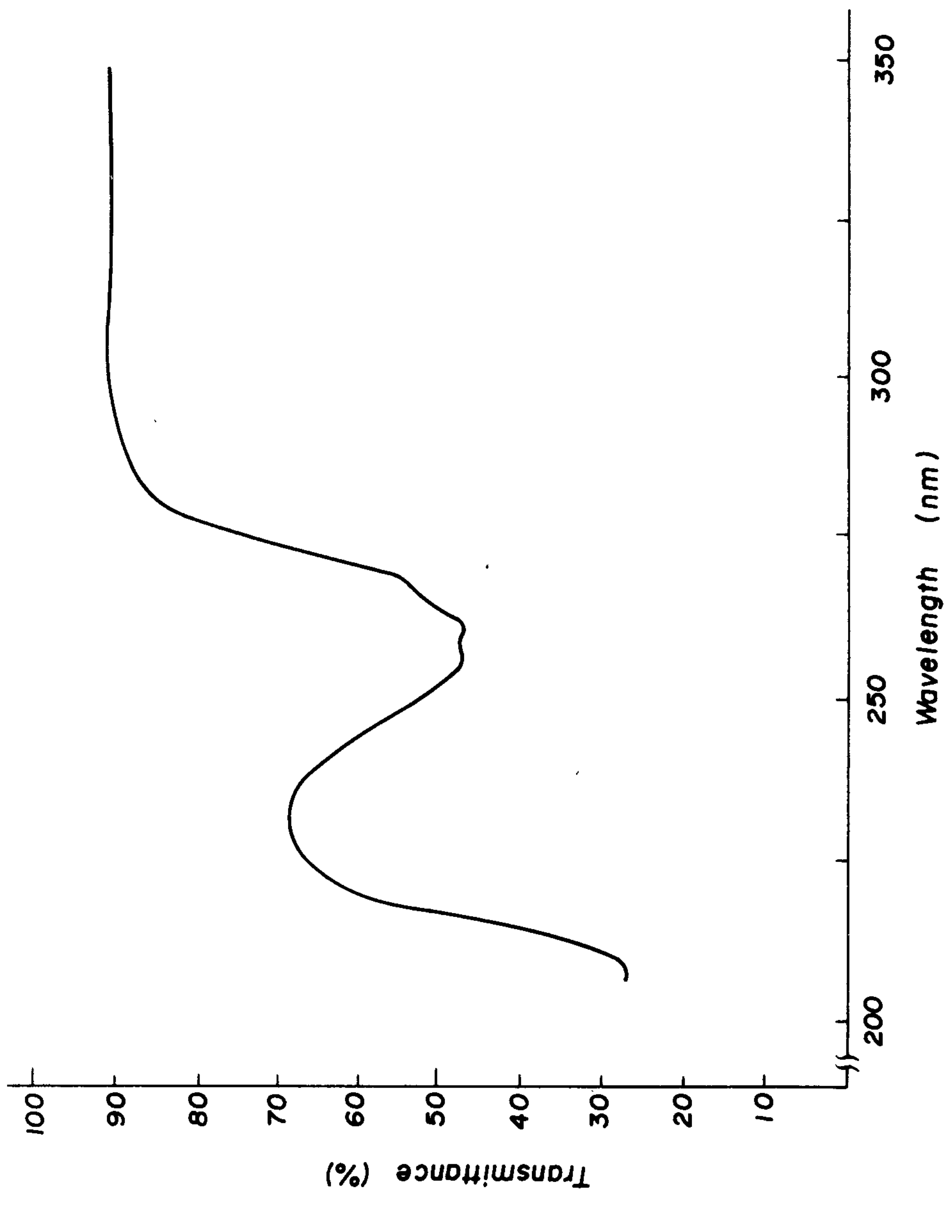
Transmittance (%)
100
90
80
70
60
50
40
30
20
10
200
250
300
350
Wavelength (nm)

FIG. 7

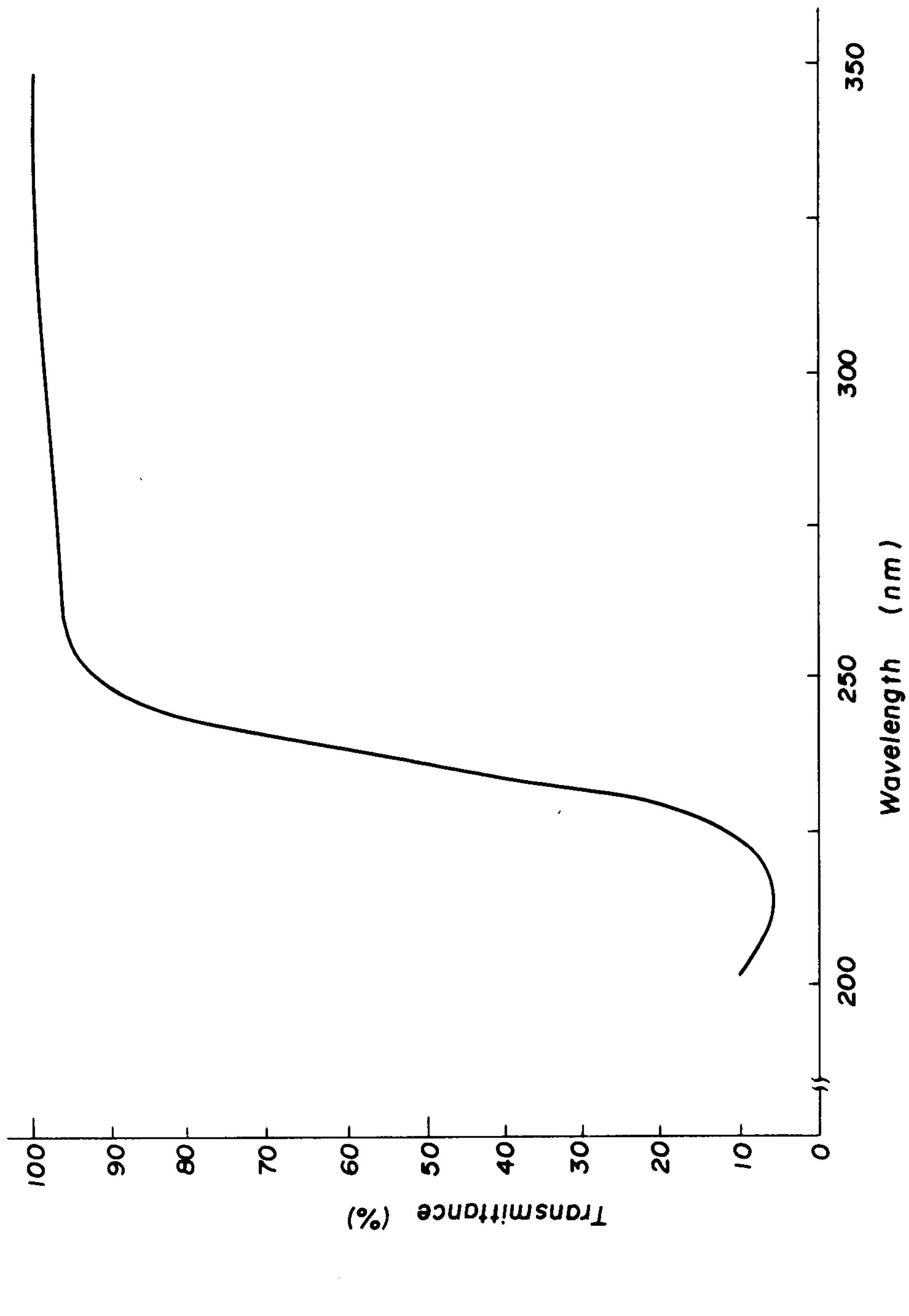
Transmittance (%)
0
10
20
30
40
50
60
70
80
90
100
Wavelength (nm)
200
250
300
350

FIG.8

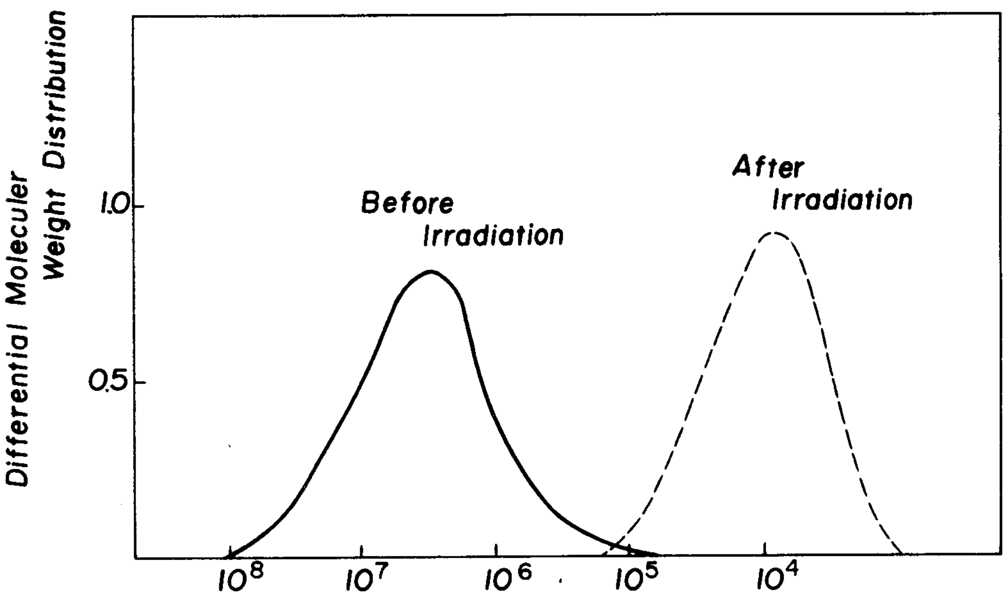
Differential Molecular Weight Distribution
1.0
0.5
Before Irradiation
After Irradiation
10⁸
10⁷
10⁶
10⁵
10⁴

FIG.10

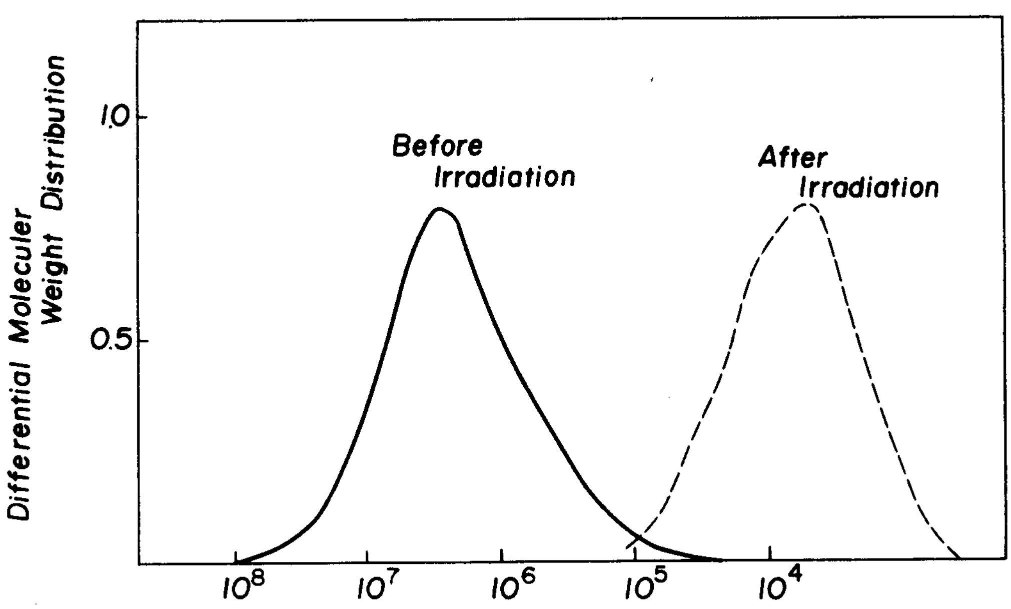
Differential Molecular Weight Distribution
1.0
0.5
Before Irradiation
After Irradiation
10⁸
10⁷
10⁶
10⁵
10⁴

FIG. 9

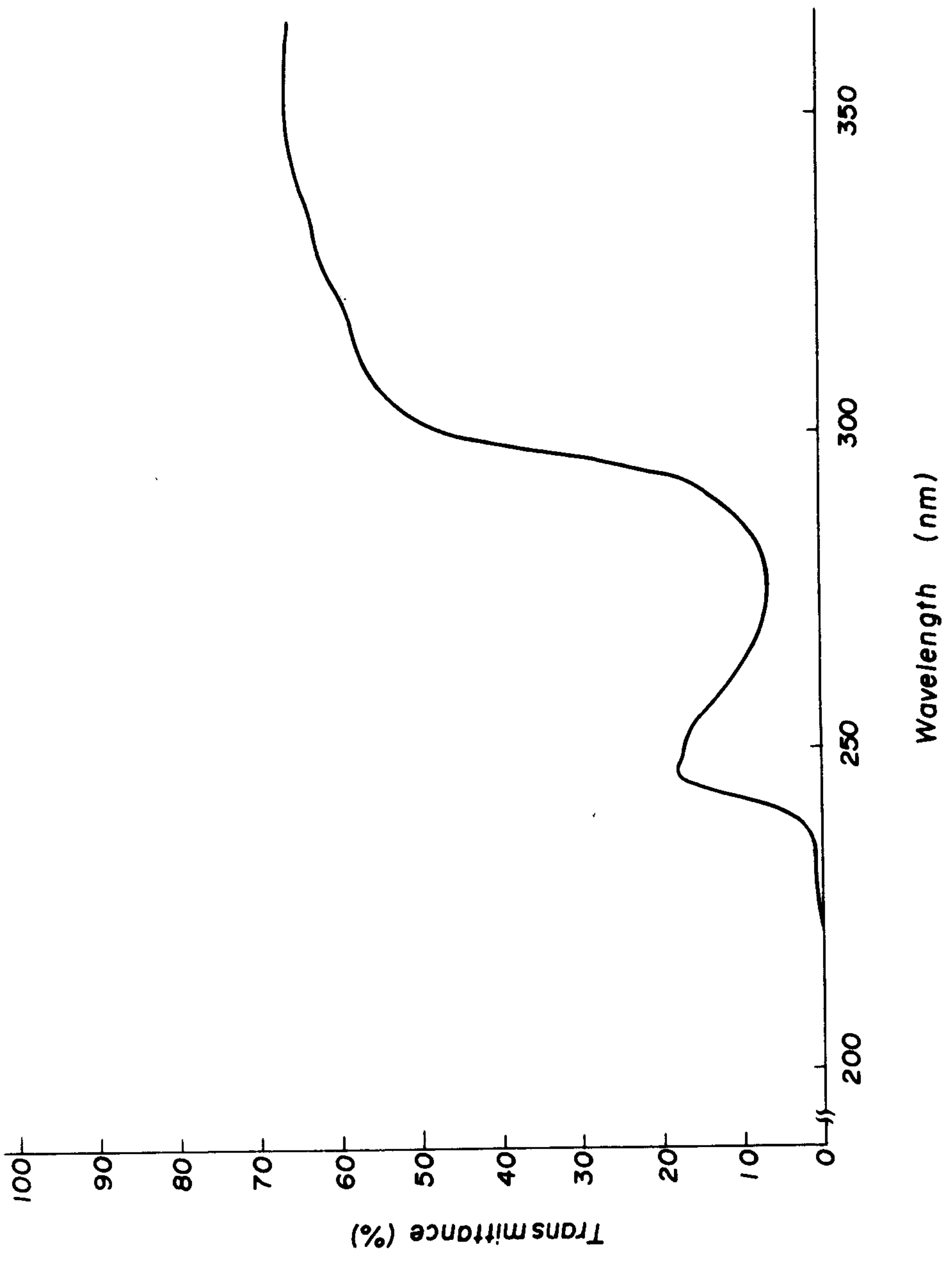
Transmittance (%)
0
10
20
30
40
50
60
70
80
90
100
200
250
300
350
Wavelength (nm)